# EUROPEAN PATENT APPLICATION

(11) **EP 3 376 599 A1**
(43) Date of publication of application: **19.09.2018**
(21) Application number: 16863720.5
(22) Date of filing: 10.11.2016
(51) Int. Cl.: H01R 4/24, H01R 4/42, G01R 21/133, G01R 1/067

(54) **DEVICE FOR MEASURING PHYSICAL MAGNITUDES ON ELECTRICAL CONDUCTOR CABLES WITH OUTER PERIPHERAL INSULATION**

(30) Priority: 11.11.2015 ES 201531632
(71) Applicant: Rodilla Sala, Vicente, 46980 Paterna (Valencia) (ES); Rodilla Valero, Sandra, 46530 Puzol (Valencia) (ES)
(72) Inventor: Rodilla Sala, Vicente, 46980 Paterna (Valencia) (ES); Rodilla Valero, Sandra, 46530 Puzol (Valencia) (ES)
(74) Representative: Capitán García, Maria Nuria
(86) International application number: PCT/ES2016/070798
(87) International publication number: WO 2017/081348

(57) **Abstract**

A device for measuring physical magnitudes on electric conductors, comprising a casing suitable for assembly on the outside of the conductor via clamping and fastening means, a metallic punch that can be lodged in the metallic core of the conductor for taking measurements and sensing electronics associated to a printed circuit board wherein the metallic punch passes tightly through a support base, the sensing electronics made up of measuring chips encapsulated with multi-chip modular (MCM) technology being fastened on the outside of said support base. The measuring device is used in a remote control and management system of an electrical installation, to optimize the conditions of safety, consumption, energy efficiency, predictive maintenance and CO₂ emissions; all this in industrial facilities, buildings and dwellings.

## Description

### FIELD OF THE INVENTION

This invention lies within the field of tools for electricity installations. Specifically, with a device suited for installation on an electrical conductor cable with outer perimetral insulation, thermoplastic or in other materials, in order to perform measurements of physical magnitudes on the core of said conductor cable, such as for example temperature, mechanical vibrations, magnetic field, amperage, voltage; among other magnitudes that allow evaluating both the state of the power grid in real time and to predict states of the power grid that we wish to prevent; such as, for example, inappropriate variations in the temperature of the conductor cable due to excessive current density [A/mm²]; or in power consumption in [kW] of grid load; or in the vibrations caused by bearings in bad condition. All this in order to optimize the energy efficiency of said load in the installation, its predictive maintenance, to be warned of technical alarms, prevent overloads, overconsumption, branching or other incidents that may affect both the producer of said load or the user thereof, and even the power supply company.

The measuring device of this invention is suited to be part of a remote control and management system for an electrical installation; which constitutes an expert system that is useful in predictive remote management of technical alarms that may occur, for example, in an industrial plant, smart building or home, etc.

### BACKGROUND OF THE INVENTION

Several programmable devices are known that monitor power consumption, which allow automatic and real time monitoring of power consumption in a home, business premises or any kind of facility, making it possible to control the total consumption of the entire facilities or for a specific area. These known devices have means to measure instant consumption values, selection and storage means for the different levels of consumption, means for indicating the different consumption levels, all of which are managed via control and processing means.

However, these known devices only allow measuring current and voltage in the conductor cable in order to control power consumption at each instant by tampering with the ends of the cables or cutting and peeling their insulation at some point of the wiring. Added to this is the fact that there are other physical magnitudes that it is crucial to measure in the conductor cable in order to monitor the state of the electrical installation; such as, for example, temperature, mechanical vibrations, magnetic field, among other magnitudes required to diagnose incidents on the load that may affect both the manufacturer of said load and the user thereof, as well as the power supply company itself.

On the other hand, infrastructures associated to power distribution such as telecommunications networks are becoming ever more common, by the use of so-called power line communication (PLC) technologies. Therefore, household power sockets and the industrial wiring of end users have become access points to a telecommunications network.

With all this, and based on currently known technology, we require the design of a device that overcomes the aforementioned disadvantages of the state of the art and solves the current associated problems, improving safety and quality of life, as well as environmental sustainability.

The applicant, after having performed an exhaustive international search, has not found any device for measuring physical magnitudes on an electrical conductor cable with outer peripheral insulation, thermoplastic or the like, with features similar to the ones disclosed in this invention.

### DESCRIPTION OF THE INVENTION

The present invention is established and characterised in the independent claims, while the dependent claims describe additional characteristics thereof.

The subject matter of the invention is a device for measuring physical magnitudes on electrical conductor cables with outer peripheral insulation, normally thermoplastic or similar, to monitor, for example, the temperature, mechanical vibrations, current, voltage, magnetic field, etc., at any point of the layout of an electrical conductor cable, without requiring cutting or peeling said cable, and without requiring access or tampering with the protective switchboards; said device also being suited to be part of a remote management and control system for an electrical installation. The device may be installed both before or after a frequency converter or any other type of load management or control system, since the device has the necessary protections and suitable power measurement algorithms.

The technical problem to be solved is to monitor the physical state at any point of the conductor cables of the electrical installations, knowing in real time the values of physical magnitudes such as temperature in [°C], [°F] or other units; the magnetic field in [Gauss], [Teslas] or other units; voltage in [V]; electric current in [A]; the real Cos ϕ per phase next to a receptor, without being affected by the interference caused by the reactive power from other loads, as occurs when measuring at the circuit boards themselves; as well as instant and cumulative power consumption of connected loads [current density in [A/mm²], power in [kW], CO₂ emissions in [kg/h] or [Ton/month], harmonics, micro-outages, energy in [kW/h], etc.; that allow instantly detecting and solving technical alarms by predictive remote management thereof, for example, using a self-learning web platform with (expert system with cloud computing).

One advantage of the invention with respect to claim 1 is that it exactly meets the object of the invention, since the configuration of the sensing electronics with chips for measuring physical magnitudes encapsulated with multi-chip module (MCM) technology as well as its placement right outside a support base from which it rests and pierces with a sharp metallic punch that acts as a sensor for several physical magnitudes (temperature, vibrations, voltage, etc.), penetrating to the metallic core of the electrical conductor cable, allows leaving the least possible distance, for example, between the chip for temperature measurement and the tip of such metallic punch, thereby limiting or minimising possible variations or dissipation between the values of the physical magnitudes measured and the conditions that actually exist inside and on the perimeter of the metallic core of the electrical conductor cable.

Another advantage with respect to claims 2 to 6 is that we manage to obtain measurements of temperature, mechanical vibrations, magnetic field, current and voltage respectively, as well as wave shape, in the electrical conductor cable, which is useful to determine and to assess the state of the electrical installation, as well as to predict states thereof that we wish to prevent (remote predictive maintenance).

Another advantage with respect to claim 7 is that we can obtain measurements of other complementary physical and chemical parameters that can be detected outside the electrical conductor cable and that can also be used to diagnose technical alarms in the installation.

Another advantage with respect to claim 8 is the fact that by providing the metallic punch with a threaded portion that threads onto the support base of said metallic punch, we can more accurately regulate the location and penetration thereof inside the metallic core of the electrical conductor cable, with a better adaptation to the different thickness of the insulation that changes from one conductor cable to another, depending on their metallic section in mm², their outer diameter and/or their manufacturer.

Another advantage with respect to claims 9, 10 and 11 is that we can form an insulated dielectric path or tunnel in which to slide the metallic punch, by insulating the outer perimeter of the electrical conductor cable. Since in many cases said insulation incorporates inside it a metallic mesh for reinforcement and/or electromagnetic insulation, this prevents said mesh from being in contact with the metallic punch, which would cause a short-circuit between said mesh and the metallic core inside the electrical conductor cable.

Another advantage with respect to claims 12 and 13 is that we can assemble the device on the perimeter of any electrical conductor cable regardless of the diameter in which it is manufactured, safely and permanently, allowing us to perform the measurements of physical magnitudes without interruptions due to disconnections between the device and the electrical conductor cable; i.e. without production cuts and/or reductions in comfort.

Another advantage with respect to claim 14 is that it facilitates operation on the metallic punch for its lodging in the metallic core of the electrical conductor cable.

Another advantage with respect to claim 15 is that it facilitates sending/receiving data between the measuring device and the control unit of the installation's remote control system, through the power grid itself.

Another advantage with respect to the use of the measuring device in a management and control system for an electrical installation is that an entire expert system with cloud computing can be set up with the capacity for learning, for remote predictive management of the electrical installation, in order to optimise its energy efficiency, to perform predictive maintenance, instantly solve technical alarms, prevent power overloads, energy overconsumption, as well as eventual electricity branching or leaks in the load (receptor).

### BRIEF DESCRIPTION OF THE DRAWINGS

This specification is supplemented with a set of drawings illustrating the preferred embodiment, which are never intended to limit the invention.
Figure 1 shows a cross-section of a front view of the measuring device for physical magnitudes assembled on an electrical conductor cable.
Figure 2 shows a magnified detail of Figure 1 of the area for clamping and anchoring the device to the electrical conductor cable, before firing or percussion of the guide of dielectric material towards said conductor cable.
Figure 3 shows a magnified detail of Figure 1 of the area for clamping and anchoring the device to the electrical conductor cable, after firing or percussion of the guide of dielectric material towards said conductor cable.
Figure 4 shows a schematic perspective view of the sensing electronics fixed to the support base of the metallic punch and associated to the printed circuit board.
Figure 5 is the same as Figure 4, but showing a second embodiment of the metallic punch with a threaded section that threads onto the support base.
Figure 6 shows a magnified detail of a first embodiment of the piercing tip of the metallic punch shown in any of the previous figures.
Figure 7 shows a magnified detail of a second embodiment of the piercing tip of the metallic punch shown in any of Figures 1 to 6.
Figure 8 shows a block diagram of the remote control system of an electrical installation that includes the physical quantity measuring device of Figure 1.

### DETAILED DESCRIPTION OF THE INVENTION

We shall now describe a preferred embodiment of the invention that is descriptive and non-limiting, based on the accompanying drawings.

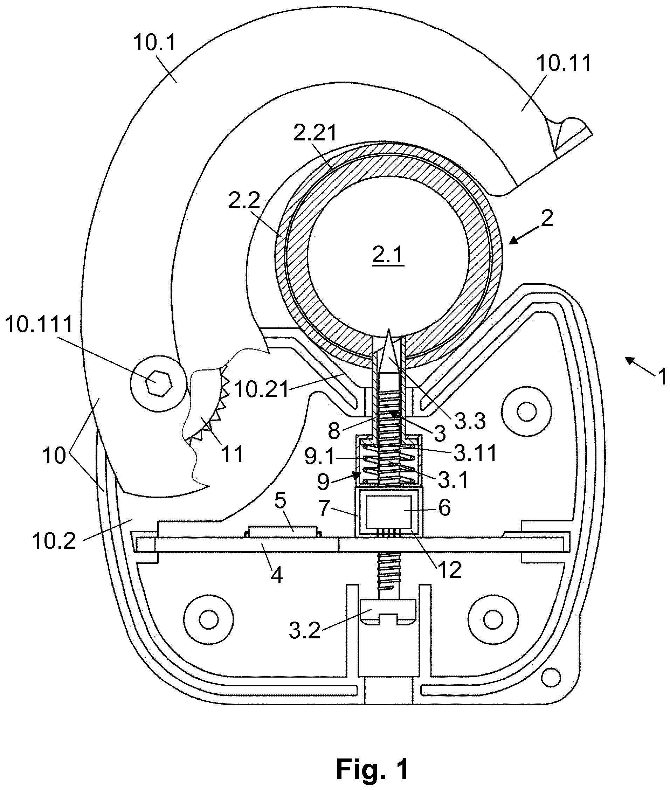

As shown in Figure 1, the measuring device (1) for physical magnitudes on an electrical conductor cable (2), the latter provided with an outer peripheral insulation (2.2), thermoplastic or similar, for example, comprises:
- a casing (10), in plastic, for example, that can be assembled on the outside of any electrical conductor cable (2) regardless of its outer diameter.
- a metallic punch (3) that lodges itself into the metallic core (2.1) of the electrical conductor cable (2), by piercing the outer peripheral insulation (2.2) of said conductor cable (2),
- a printed circuit board (4) comprising a modem (5) that sends/receives data via encoded signals, said modem (5) preferably comprising power line communication (PLC) technology and the encoded signals are sent/received via the electrical conductor cable (2) in which the metallic punch (3) is lodged, and
- sensing and data processing electronics (6) for several physical magnitudes associated to the printed circuit board (4).

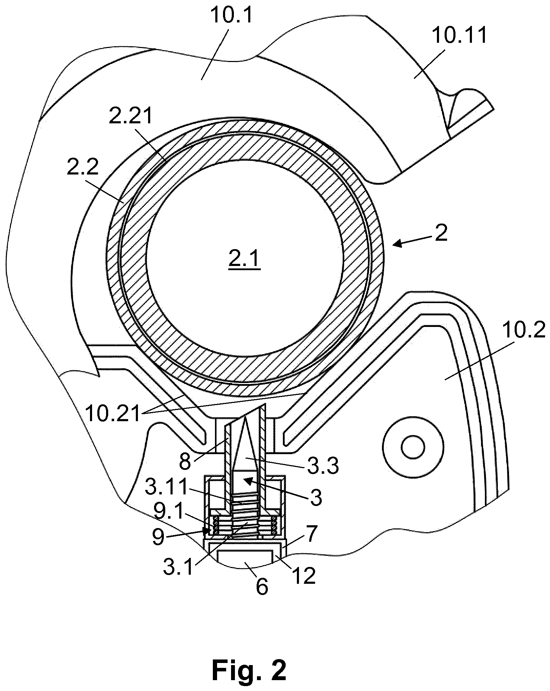

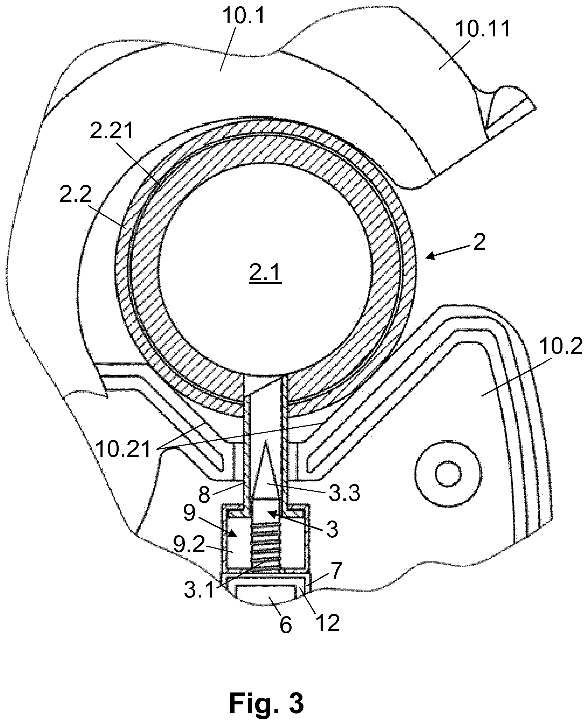

Preferably, as seen in Figures 2 and 3, the assembly of the measuring device (1) on the electrical conductor cable (2) is carried out by clamping and fastening means (10.1) of the casing (10); which comprise a hook-shaped pivoting arm (10.11) that clamps and holds said conductor cable (2) against a V-shaped seat (10.21) of a casing body (10.2) of the casing (10) of the device (1) for its self-centring.

Similarly, we prefer that the pivoting arm (10.11) is joined to the casing body (10.2) via a rotating shaft (10.111) with a locking mechanism (11) of the ratchet kind, by which the device (1) is adjusted and fastened to the corresponding outer diameter of the electrical conductor cable (2).

The combination of the V-shaped seat (10.21) and the hook-shaped pivoting arm (10.11) with the locking mechanism (11) allows achieving a solid and tight fastening of the measuring device (1) to the electrical conductor cable (2) regardless of the outer diameter of the cable.

With respect to the metallic punch (3), we prefer it to slide inside a guide of dielectric material (8) such as ceramic, for example, carbon fibre, or any other dielectric material of great hardness and strength, with the free end having a needle shape, that is, with a sharp tip with a bevelled end shape.

Before lodging the metallic punch (3) in the metallic core (2.1) of the conductor cable (2) the guide in dielectric material (8) is shot or fired radially towards the inside of said conductor cable (2) by releasing thrusting means (9) such as a spring (9.1), for example, as shown in Figures 1 and 2, or a gas piston (9.2) like the one represented in Figure 3; in either case, said thrusting means (9) are initially pretensed or held via a pre-load inside the casing (10). See Figure 2.

The release of the thrusting means (9) can be performed manually or automatically after activating the locking mechanism (11) of the pivoting arm (10.11); for example, by pushing the shell consisting of the casing (10) (pivoting arm (10.11) plus casing body (10.2)) of the device (1) against the electrical conductor cable (2), the latter placed against the V-shaped seat (10.21) of the casing body (10.2). Then, since the conductor cable (2) is firmly held between the pivoting arm (10.11) and the seat (10.21) of the casing (10) and the thrusting means (9) are released, the sharp guide in dielectric material (8) is fired against said electrical conductor cable (2), piercing all the insulation and protection layers or the metallic mesh for reinforcement and/or electromagnetic insulation (2.21) that may form the outer peripheral insulation (2.2) of said conductor cable (2) to thus establish a dielectric tunnel between the sensing electronics (6) of the device (1) and the metallic core (2.1) of the conductor cable (2) eliminating the chance of short-circuits with said metallic mesh (2.21) that may surround said electrical conductor cable (2).

That is, that as shown in Figure 3, when the outer peripheral insulation (2.2) of the electrical conductor cable (2) is pierced, the guide in dielectric material (8) constitutes a dielectric path for the metallic punch (3). Thus, the metallic punch (3) is insulated from a possible metallic mesh (2.21) provided inside the outer peripheral insulation (2.2) of some electrical conductor cables (2). We thus prevent short-circuits between the mesh (2.21) and the metallic core (2.1) of the electrical conductor cable (2).

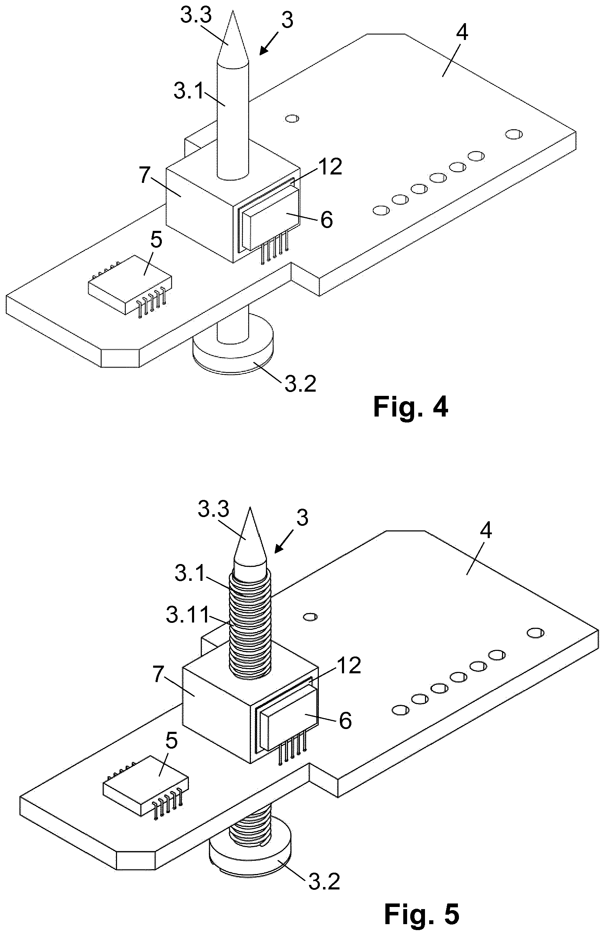

Similarly, as shown in Figures 4 and 5, the metallic punch (3) comprises a sharp lodging tip (3.3) followed by a central portion (3.1). The latter is arranged such that it tightly fits through a support base (7) for said metallic punch (3) that is fixed to the electronics plate (4) inside the casing (10) of the measuring device (1).

Thus, the metallic punch (3) can slide in a tight manner through the support base (7), the latter allowing holding the metallic punch (3) while it becomes lodged inside the metallic core (2.1) of the conductor cable (2), at the same time as it guarantees the continuity (both electrical and thermal) necessary for the sensing electronics (6) to perform the corresponding measurements of the physical magnitudes on the metallic core (2.1).

In a preferred embodiment, shown in figures 1, 2, 3 and 5, the central portion (3.1) of the metallic punch (3) comprises a threaded section (3.11) that threads onto the support base (7). We can thus more accurately regulate the placement and penetration of the metallic punch (3) in the metallic core (2.1) of the electrical conductor cable (2).

Preferably, the metallic punch (3) comprises, on the end opposite the lodging tip (3.3) an actuating head (3.2) adapted to receive the tip of a screwdriver or other manual or automatic tool (not shown in the figures). The actuation on said head (3.2) makes the metallic punch (3) slide through the support base (7) and the guide in dielectric material (8) so that it penetrates and lodges itself in the metallic core (2.1) of the electrical conductor cable (2). The measuring device (1) may include a standard optical indicator, LED or the like (not shown in the figures), to show that the metallic punch (3) has contacted the metallic core (2.1) of the conductor cable (2) and that there is continuity for the reading of temperature, vibrations, electric voltage, and PLC communication when relevant.

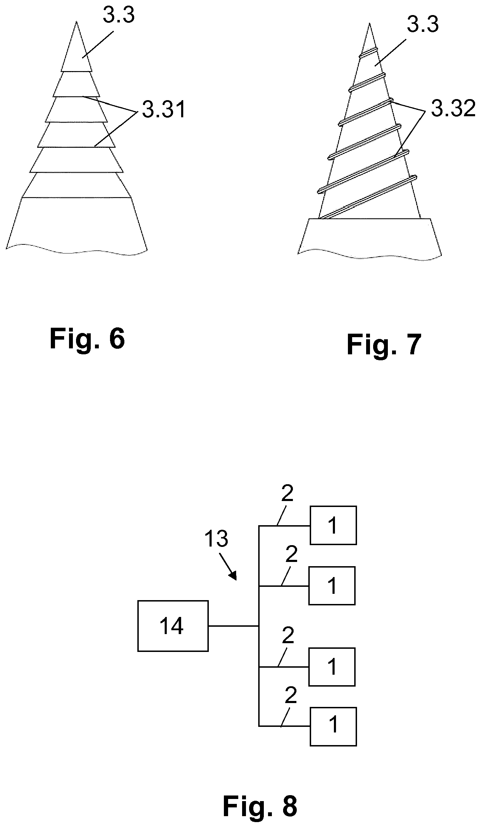

For its part, the lodging tip (3.3) of the metallic punch (3) can comprise anti-slip ribs, with a frustoconical shape (3.31), for example, or a thread of the screw-lock type (3.32), see figures 6 and 7 respectively, in order to prevent it from dislodging from the metallic core (2.1) for example, due to vibrations or heat contractions.

Preferably, the metallic punch (3) is made in a copper alloy or any other with a hardness and mechanical strength that guarantee adequate penetration into the metallic core (2.1) of the electrical conductor cable (2) and high electrical and heat conductivity, but with a composition such that it does not generate galvanic currents with the copper or other materials of said metallic core (2.1) of the electrical conductor cable (2), preventing its corrosion or wear.

The device (1) is thus ready for taking measurements as well as for sending and receiving encoded signals, preferably, via power line communication technology (PLC) towards a control unit (14) of the remote management system of an electrical installation (13) in which said measuring device (1) is installed. See Figure 8.

On the other hand, as shown in figures 4 and 5, the sensing electronics, that is, the electronic elements that measure at least one physical quantity in the electrical conductor cable (2) are fastened on the outside of a support base (7) of the metallic punch (3). The sensing electronics (6) comprise measuring chips (silicon/DIES) encapsulated with multi-chip module technology (MCM). The chips that make up the sensing electronics (6) are thus guaranteed to be as close as possible to the lodging tip (3.3) of the metallic punch (3), thus limiting or minimising possible variations or dissipations between the values of the physical magnitudes measured and the and the actual conditions that exist in the electrical conductor cable (2).

Preferably, the sensing electronics (6) can comprise at least one, all, or any combination of the following electronic components:
- a heat chip that measures temperature; for example, capable of measuring the heat-time gradient existing at different depths or radii of the electrical conductor cable (2),
- an accelerometer and gyroscope chip that measures mechanical vibrations in the electrical conductor cable (2) from engines, pumps or other electrical loads connected to the electrical conductor cable (2) with the sensor,
- an inductometer chip that takes 3d measurements of the magnetic field on the electrical conductor cable (2) for its analogue and digital magnetographic representation,
- a magneto-resistive chip that measures values of the current circulating through the electrical conductor cable (2) according to the electric resistance or impedance caused by the magnetic field induced by the current itself within said electrical conductor cable (2), and
- an electrical network analyser chip that integrates measurements of voltage, intensity and wave shape measured within the electrical conductor cable (2); including the corresponding harmonics and eventual micro-outages of power supply.

Similarly, the sensing electronics (6) might comprise at least one chip that measures smoke, ionizing radiation, parameters of gases, liquids, solids, such as weight, pressure, humidity, flow rate, density, viscosity, colorimetry, and/or luminosity outside the electrical conductor cable (2) or other parameters required for the installation.

Similarly, the sensing electronics (6) might comprise a geodesic locator (GPS), for geolocation of the device (1) either by cellular or satellite telephone communications or other similar means.

In any case we prefer that between the support base (7) of the metallic punch (3) and the sensing electronics (6) there are dielectric means (12) that guarantee high heat conductivity between said parts, for example, for temperature measurements, while at the same time insulating the electronics (6) from electric voltage, in compliance with international electromagnetic safety and compatibility regulations.

On the other hand, the power supply for the measuring device (1) is preferred to be through the metallic punch (3) with the voltage from the electrical conductor cable (2) it is attached to, through a switching source or the like. However, some other external power supply known in the state of the art could also be provided.

Figure 8 shows the remote control and management system for the electrical installation (13) consisting of at least one measuring device (1) described above measuring physical magnitudes on an electrical conductor cable (2) of said installation (13).

The physical magnitudes measured by the measuring device (1) are communicated to the control unit (14) of the control system for processing and management. Similarly, additional information may be received, for example, on the geodesic position (GPS) of the device (1) in the network, the existence or not of electric contact between said device (1) and the metallic core (2.1) of the conductor cable (2) on which it is assembled, amongst other useful information for control of the electrical installation (13).

The control unit (14) comprises a micro-controller (not shown in the figures) for processing the information received, information storage means (not shown in the figures), for example for the historical log of measurements, as well as, means for communications (not shown in the figures), making up an entire expert control system self-learning with capacities and supported by architecture for big-data in cloud computing.

Preferably, the sending and receiving of encoded signals between the measuring device (1) and the control unit (14) of the remote control system of the electrical installation (13) is performed via power line communication technology (PLC), however, other known forms of communication could be used, either wireless or through cables.

Therefore, from the processing of the information received in the control system, the control unit (14) remotely configures, calibrates and provides predictive maintenance for each of the measuring devices (1) in the system.

From a standard control and management panel (not shown in the figures), with M2M technology for Big-Data, for example, the following actions can be performed from the control unit (14):
- automatic report generation,
- automatic ad-hoc management upon technical alarms detected by the measuring devices (1),
- remote management of loads, either manually or automatically, when detecting excesses over predefined load limits, for example, when disconnecting one or more of the devices connected to the network,
- checking stored historical logs of measurements,
- remote configuration and maintenance of the measuring devices (1),
- other actions.

Such actions may even be visualised and managed via a mobile electronic device such as a laptop, tablet, smartphone, etc., that can be connected to said control and management panel via a local network or the internet.

## Claims

1. A device for measuring physical magnitudes (1) on an electrical conductor cable (2) with outer peripheral insulation (2.2), comprising:
- a casing (10) that can be mounted on the outside of the electrical conductor cable (2) via clamping and fastening means (10.1),
- a metallic punch (3) that lodges itself into the metallic core (2.1) of the electrical conductor cable (2), by piercing the outer peripheral insulation (2.2) of said conductor cable (2) to take measurements,
- a printed circuit board (4) comprising a modem (5) that sends/receives data via encoded signals,
- sensing and data processing electronics (6) associated to the printed circuit board (4), **characterised in that** the metallic punch (3) comprises a central portion (3.1) that pierces in a fitted manner a support base (7) of the metallic punch (3); outside of said support base (7) are attached the sensing electronics (6) comprising encapsulated chips with multi-chip modular technology (MCM) to measure physical magnitudes on the electrical conductor cable (2).

2. A device according to claim 1, wherein the sensing electronics (6) comprise a thermal chip that performs temperature measurements on the electrical conductor cable (2) at different depths according to the radius thereof.

3. A device according to any of the previous claims, wherein the sensing electronics (6) comprise an accelerometer and gyroscope chip that measures the vibrations transmitted by the electrical conductor cable (2).

4. A device according to any of the previous claims, wherein the sensing electronics (6) comprise an inductometer chip that performs 3D measurements of the magnetic field on the electrical conductor cable (2) for magnetographic representation, both analogical and digital.

5. A device according to any of the previous claims, wherein the sensing electronics (6) comprise a magnetoresistive chip that measures values of the current circulating through the electrical conductor cable (2) according to the electric resistance or impedance caused by the magnetic field induced by the current itself that is circulating through said electrical conductor cable (2).

6. A device according to any of the previous claims, wherein the sensing electronics (6) comprise an electrical network analyser chip that integrates measurements of voltage, intensity and wave shape, measured in the electrical conductor cable (2), including the corresponding harmonics and eventual micro-cuts in power supply.

7. A device according to any of the previous claims, wherein the sensing electronics (6) comprise at least one chip that performs measurements of smoke, ionizing radiation, gases, liquids, solids, weight, pressure, humidity, flow rate, density, viscosity, colorimetry and/or luminosity outside the electrical conductor cable (2).

8. A device according to claim 1, wherein the central portion (3.1) of the metallic punch (3) comprises a threaded section (3.11) that threads onto the support base (7).

9. A device according to claim 1, wherein the metallic punch (3) slides inside a guide of dielectric material (8) with the free end sharpened into a needle shape that when it pierces the outer peripheral insulation (2.2) of the electrical conductor cable (2) forms a dielectric passage for the metallic punch (3) that connects the sensing electronics (6) with the metallic core (2.1) of the conductor cable (2).

10. A device according to claim 9, wherein the guide of dielectric material (8) is radially shot towards the inside of the electrical conductor cable (2) piercing its outer peripheral insulation (2.2) when a thrusting means (9) is released.

11. A device according to claim 10, wherein the thrusting means (9) is a spring (9.1) or a gas piston (9.2).

12. A device according to claim 1, wherein the clamping and fastening means (10.1) comprise a hook shaped pivoting arm (10.11) that clasps and holds the electrical conductor cable (2) against a v-shaped seat (10.21) of a casing body (10.2) of the casing (10).

13. A device according to claim 12, wherein the pivoting arm (10.11) is joined to the casing body (10.2) via a rotation axis (10.111) with a locking mechanism (11) of the ratchet kind, the locking mechanism (11) adjusts the assembly of the device (1) to the outer diameter of the electrical conductor cable (2), allowing its solid and fitted fastening to the same.

14. A device according to claim 1, wherein the metallic punch (3) comprises an actuating head (3.2) that is adapted in order to receive a manual or an automatic tool.

15. A device according to claim 1, wherein the modem (5) comprises power line communications (PLC) technology, and the encoded signals are sent/received via the electrical conductor cable (2) into which the metallic punch (3) is driven.
